(19) Europäisches Patentamt
European Patent Office
Office européen des brevets

(11) **EP 0 918 363 B1**

(12) **EUROPÄISCHE PATENTSCHRIFT**

(45) Veröffentlichungstag und Bekanntmachung des Hinweises auf die Patenterteilung:
**14.03.2001 Patentblatt 2001/11**

(51) Int Cl.[7]: **H01M 8/04**, G01R 31/36

(21) Anmeldenummer: **97120389.8**

(22) Anmeldetag: **20.11.1997**

(54) **Verfahren und Vorrichtung zum Überwachen einer ausgewählten Gruppe von Brennstoffzellen eines Hochtemperatur-Brennstoff-zellenstapels**

Method and device for monitoring a selected group of fuel cells of a high temperature fuel cell stack

Procédé et dispositif de controle d'un groupe sélectionné de piles à combustible d'un empilement de piles à combustible fonctionnant à haute température

(84) Benannte Vertragsstaaten:
**AT DE FR GB IT NL**

(43) Veröffentlichungstag der Anmeldung:
**26.05.1999 Patentblatt 1999/21**

(73) Patentinhaber: **SIEMENS AKTIENGESELLSCHAFT**
**80333 München (DE)**

(72) Erfinder:
• **Zeilinger, Reinhold**
**91468 Pahres (DE)**
• **Stühler, Walter**
**96144 Hirschaid (DE)**
• **Keim, Martin**
**91056 Möhrendorf (DE)**

(56) Entgegenhaltungen:
WO-A-91/19328          DE-A- 4 338 178
DE-A- 19 523 260          US-A- 4 424 491

• PATENT ABSTRACTS OF JAPAN vol. 012, no. 379 (E-667), 11.Oktober 1988 -& JP 63 126172 A (TOSHIBA CORP), 30.Mai 1988,
• PATENT ABSTRACTS OF JAPAN vol. 012, no. 158 (E-608), 13.Mai 1988 -& JP 62 271357 A (NIPPON KOKAN KK), 25.November 1987,
• DATABASE WPI Section EI, Week 9748 Derwent Publications Ltd., London, GB; Class X16, AN 97-518631 XP002064467 & JP 09 245 826 A (EQUOS RES KK)
• PATENT ABSTRACTS OF JAPAN vol. 018, no. 626 (E-1636), 29.November 1994 & JP 06 243882 A (FUJI ELECTRIC CO LTD), 2.September 1994,
• PATENT ABSTRACTS OF JAPAN vol. 097, no. 003, 31.März 1997 & JP 08 315844 A (TOSHIBA CORP), 29.November 1996, & DATABASE WPI Derwent Publications Ltd., London, GB; AN 97-70362
• PATENT ABSTRACTS OF JAPAN vol. 010, no. 268 (E-436), 12.September 1986 & JP 61 091877 A (TOSHIBA CORP), 9.Mai 1986,

**Beschreibung**

Die Erfindung bezieht sich auf ein Verfahren und auf eine Vorrichtung zum Überwachen einer ausgewählten Gruppe von Brennstoffzellen eines Brennstoffzellenstapels.

Es ist bekannt, daß bei der Elektrolyse von Wasser die Wassermoleküle durch elektrischen Strom in Wasserstoff ($H_2$) und Sauerstoff ($O_2$) zerlegt werden. In einer Brennstoffzelle läuft dieser Vorgang in umgekehrter Richtung ab. Durch eine elektrochemische Verbindung von Wasserstoff ($H_2$) und Sauerstoff ($O_2$) zu Wasser entsteht elektrischer Strom mit hohem Wirkungsgrad und, wenn als Brenngas reiner Wasserstoff ($H_2$) eingesetzt wird, ohne Emission von Schadstoffen und Kohlendioxid ($CO_2$). Auch mit einem technischen Brenngas, beispielsweise Erdgas oder Kohlegas, und mit Luft (die zusätzlich mit Sauerstoff ($O_2$) angereichert sein kann) anstelle von reinem Sauerstoff ($O_2$) erzeugt eine Brennstoffzelle deutlich weniger Schadstoffe und weniger Kohlendioxid ($CO_2$) als andere Energieerzeuger, die mit fossilen Energieträgern arbeiten. Die technische Umsetzung des Prinzips der Brennstoffzelle hat zu unterschiedlichen Lösungen, und zwar mit verschiedenartigen Elektrolyten und mit Betriebstemperaturen zwischen 80 °C und 1000 °C, geführt.

In Abhängigkeit von ihrer Betriebstemperatur werden die Brennstoffzellen in Nieder-, Mittel- und Hochtemperatur-Brennstoffzellen eingeteilt, die sich wiederum durch verschiedene technische Ausführungsformen unterscheiden.

Bei dem aus einer Vielzahl von Hochtemperatur-Brennstoffzellen sich zusammensetzenden Hochtemperatur-Brennstoffzellenstapel (in der Fachliteratur wird ein Brennstoffzellenstapel auch "Stack" genannt) liegen unter einer oberen Verbundleiterplatte, welche den Hochtemperatur-Brennstoffzellenstapel abdeckt, der Reihenfolge nach wenigstens eine Schutzschicht, eine Kontaktschicht, eine Elektrolyt-Elektroden-Einheit, eine weitere Kontaktschicht, eine weitere Verbundleiterplatte, usw.

Die Elektrolyt-Elektroden-Einheit umfaßt dabei zwei Elektroden und einen zwischen den beiden Elektroden angeordneten, als Membran ausgeführten Festelektrolyten. Dabei bildet jeweils eine zwischen benachbarten Verbundleiterplatten liegende Elektrolyt-Elektroden-Einheit mit den beidseitig an der Elektrolyt-Elektroden-Einheit unmittelbar anliegenden Kontaktschichten eine Hochtemperatur-Brennstoffzelle, zu der auch noch die an den Kontaktschichten anliegenden Seiten jeder der beiden Verbundleiterplatten gehören. Dieser Typ und weitere Brennstoffzellen-Typen sind beispielsweise aus dem "Fuel Cell Handbook" von A. J. Appleby und F. R. Foulkes, 1989, Seiten 440 bis 454, bekannt.

Ein Stapel von Brennstoffzellen besitzt in der Regel wenigstens 50 Zellen. Um zu erkennen, ob und wo eine Zelle im Stapel defekt ist, muß der Stapel während der gesamten Betriebsdauer überwacht werden. Bei einem Leck können nämlich größere Schäden an der Anlage entstehen und/oder Wasserstoffgas unkontrolliert in die Umgebung austreten (Explosionsgefahr), wobei eine Brennstoffzelle auf ein Leck in der Regel sofort mit einer Polarisationsumkehr ihrer Spannung reagiert. Ein solcher Zustand muß daher schnell erkannt werden, um die betreffende Zelle abzuschalten. Es ist aufgrund des großen technischen Aufwandes nicht möglich, jede Zelle einzeln zu überwachen. Zwecks einer praktischen funktionellen Überwachung werden jeweils mehrere Zellen zu einer Gruppe zusammengefaßt, wobei diese einzelnen Gruppen mit den anderen Gruppen des Stapels verglichen werden.

Aus dem Europäischen Patent 0 486 654 ist ein Verfahren zur Funktions- bzw. Leistungsüberwachung von mehreren elektrisch in Reihe geschalteten Zellen bekannt. Beim Verfahren werden die Zellen des Stapels zunächst in Gruppen unterteilt. Zu einem bestimmten Zeitpunkt werden die elektrischen Spannungen der Gruppen erfaßt und die normierten gemessenen Spannung jeder Gruppe mit einer ersten elektrischen Bezugsspannung verglichen, welche gleich einer vorgegebenen minimalen Spannung ist. Zusätzlich werden auf unterschiedliche Weise die Spannungen der einzelnen Gruppen miteinander verglichen. In einem ersten Ausführungsbeispiel wird jeweils die Spannung einer ausgewählten Gruppe mit den Spannungen der anderen Gruppen verglichen. In einem zweiten Ausführungsbeispiel werden nacheinander jeweils zwei benachbarte Gruppen ausgewählt und miteinander verglichen. In einem dritten Ausführungsbeispiel wird die Summe der Spannungen der einzelnen Brennstoffzellengruppen gebildet und durch die Zahl der Brennstoffzellengruppen dividiert; anschließend wird dieser Wert mit jeder einzelnen Gruppe verglichen. Beim Verfahren zum Überwachen werden hier in einem vorgegebenen Überwachungsintervall die Spannungen der einzelnen Gruppen von Zellen auf die verschiedenartigste Weise miteinander verglichen. Das Verfahren basiert somit auf einer Vielzahl von Vergleichen.

Bei einem weiteren bekannten Verfahren wird ein Schwellwert für die elektrische Spannung bestimmt, der in Abhängigkeit vom elektrischen Strom ausgegeben wird. Die elektrischen Spannungen der einzelnen Gruppen werden anschließend mit dem Schwellwert verglichen. Da der Schwellwert aus einem Strommeßwert ermittelt wird, der zu einem anderen Zeitpunkt gemessen wird als die elektrischen Spannungen der Gruppen (der Schwellwert muß vor dem Vergleich erst berechnet werden), tritt gegebenenfalls ein Fehler auf, wenn der Schwellwert und die elektrischen Spannungen der Gruppen zu verschiedenen Betriebszuständen des Stapels gehören.

Der Erfindung liegt nun die Aufgabe zugrunde, den Ausfall einer Brennstoffzelle eines Brennstoffzellenstapels mit einfachen Mitteln zuverlässig zu erkennen.

Gemäß der Erfindung wird eine ausgewählte Gruppe von Brennstoffzellen eines Brennstoffzellenstapels dadurch überwacht, daß die zeitliche Änderung der gemittelten Spannung der Zellen der ausgewählten Gruppe ermittelt und verglichen wird mit einem Bezugswert, der mindestens die zeitliche Änderung der Spannung anderer Zellen des Stapels erfaßt.

Da also zeitliche Spannungsänderungen erfaßt und verglichen werden, besitzt das Verfahren gegenüber Laständerungen des Stapels eine hohe Dynamik. Durch das Verfahren kann mit einfachen Mitteln zuverlässig erkannt werden, ob eine Zelle der ausgewählten Gruppe ausgefallen ist oder jedenfalls nicht die ordnungsgemäße Spannung liefert.

Vorzugsweise ist die Gesamtheit der Zellen des Stapels in mehrere Gruppen aus unmittelbar in Reihe geschalteten Zellen aufgeteilt, wobei nur die Eingangsspannung der ersten Zelle einer Gruppe und die Ausgangsspannung der letzten Zelle dieser einen Gruppe gemessen wird. Die Gruppen weisen beispielsweise jeweils eine Anzahl von 10 Zellen auf, deren Spannungen also gruppenweise erfaßt werden, nämlich durch die Spannungsdifferenz am Eingang und Ausgang jeder Gruppe. Es braucht nicht die elektrische Spannung jeder einzelnen Zelle dieser Gruppe erfaßt werden. Die Nachweiswahrscheinlichkeit des Verfahrens reicht für Gruppen mit einer verhältnismäßig großen Anzahl von Zellen aus.

Insbesondere kann als zeitliche Änderung der Spannung einer Gruppe die relative Änderung der Differenz zwischen der Eingangsspannung der ersten Zelle und der Ausgangsspannung der letzten Zelle ermittelt werden. Es kann die Differenz der elektrischen Spannung dieser Gruppe zu zwei verschiedenen Zeitpunkten erfaßt werden, wobei der Abstand dieser beiden Zeitpunkte beispielsweise 0,5 s beträgt.

In einer weiteren Ausgestaltung der Erfindung wird als gemittelte Spannung der Zellen der ausgewählten Gruppe die Summe der Spannungen der Zellen gemessen und durch die Zahl der Zellen dividiert. Durch Division der aufsummierten Spannung durch die Anzahl der Zellen ist eine Unabhängigkeit von der Gruppengröße (d.h. von der Anzahl der Zellen in der Gruppe) gegeben. Die Gruppen müssen nun nicht mehr alle die gleiche Anzahl von Zellen aufweisen.

Insbesondere kann der Bezugswert die Spannungen aller Zellen des Stapels und deren Änderungen erfassen, die nicht zur ausgewählten Gruppe gehören. Damit ist eine sehr zuverlässige Überwachung des Stapels gewährleistet, da ein Defekt in einer Zelle der ausgewählten Gruppe den Bezugswert nicht beeinflußt, und ein Defekt in einer anderen Zelle den Bezugswert nur geringfügig verfälscht.

In einer weiteren Ausgestaltung der Erfindung wird zusätzlich die gemittelte Spannung der ausgewählten Gruppe mit einem Mittelwert verglichen, der die Spannungen aller oder mindestens anderer Zellen des Stapels umfaßt. Durch Vergleich der ausgewählten Gruppe mit dem Mittelwert der Spannung ist eine zuverlässige Überwachung gewährleistet, da eine defekte Zelle in der ausgewählten Gruppe nur verhältnismäßig schwach oder - wenn dabei keine Zellen der ausgewählten Gruppe enthalten sind - überhaupt nicht in den Mittelwert eingeht.

Das Verfahren gestattet, gleichzeitig alle Zellen des Stapels zu überwachen, indem jede Zelle als Mitglied mindestens einer ausgewählten Gruppe überwacht wird.

Vorzugsweise wird jede Zelle des Stapels redundant als Mitglied mindestens zweier ausgewählter Gruppen überwacht. Durch geeignete Aufteilung der Zellen des Stapels in Gruppen wird die Genauigkeit zum Lokalisieren einer ausgefallenen Zelle erhöht.

Insbesondere kann die redundante Überwachung mittels redundanter Verarbeitungseinrichtungen für die gemessenen Spannungen vorgenommen werden. Diese Hardwareredundanz gewährleistet bei Ausfall einer Verarbeitungseinrichtung dennoch die Überwachung des gesamten Stapels.

Das erfindungsgemäße Verfahren wird in einer Überwachungseinrichtung mit einer aktivierbaren Rechenstufe durchgeführt, der zum Überwachungszeitpunkt Spannungsdifferenzen, die am Stapel abgegriffen sind, aufgeschaltet und mit zu einem früheren Zeitpunkt abgegriffenen Differenzen verglichen sind.

Die Abgriffe entsprechen einer Aufteilung der Zellen in Gruppen, wobei bevorzugt - abgesehen von den beiden Gruppen am Eingang und Ausgang des Stapels - alle Gruppen die gleiche Anzahl von Zellen enthalten. Die an einer Gruppe abgegriffene Spannungsdifferenz liefert die gemittelte Spannung der Zellen dieser Gruppe, und der Vergleich einer zu verschiedenen Zeitpunkten abgegriffenen Spannungsdifferenz liefert deren zeitliche Änderung.

Der entsprechende Bezugswert, mit dem die Spannungsänderung dieser Gruppe verglichen wird, kann aus den Änderungen der anderen (oder aller) abgegriffenen Spannungsdifferenzen gebildet werden. Für eine redundante Überwachung der Zellen ergibt sich vorteilhaft eine Vorrichtung, bei der die in Reihe geschalteten Brennstoffzellen des Brennstoffzellenstapels zu einem vorgegebenen Zeitpunkt mittels mindestens zweier Überwachungseinrichtungen überwacht werden. Dabei sind über Abgriffe und Signalleitungen jeder Überwachungseinrichtung Spannungen aufgeschaltet, die jeweils zwischen benachbarten Brennstoffzellen abgegriffen sind, wobei diese Abgriffe so angeordnet sind, daß sich mindestens bei zwei Abgriffen (bevorzugt: jeweils zwischen zwei Abgriffen), die der einen (ersten) Überwachungseinrichtung aufgeschaltet sind, mindestens für eine weitere (bevorzugt: für jede weitere) Überwachungseinrichtung noch ein weiterer Abgriff befindet.

Jede Überwachungseinrichtung enthält eine aktivierbare Rechenstufe, die mehrere Differenzen der zu einem Zeitpunkt aufgeschalteten Spannungen mit entsprechenden Differenzen von zu einem früheren Zeitpunkt aufgeschalteten Spannungen vergleicht.

Die der ersten Einrichtung aufgeschalteten Abgriffe entsprechen einer ersten Aufteilung der Zellen des Stapels in Gruppen, und genauso gehört zu jeder anderen Einrichtung ebenfalls eine Gruppenaufteilung, wobei jeweils die Zellen einer Gruppe gemeinsam von der zugehörigen Überwachungseinrichtung überwacht werden. Wenn auch jede Überwachungseinrichtung jeweils die ersten und letzten Zellen des Stapels überwachen soll, ist auch jeder Überwachungseinrichtung die Eingangsspannung und Ausgangsspannung des Stapels aufgeschaltet.

Weitere vorteilhafte Ausgestaltungen sind in den Unteransprüchen wiedergegeben.

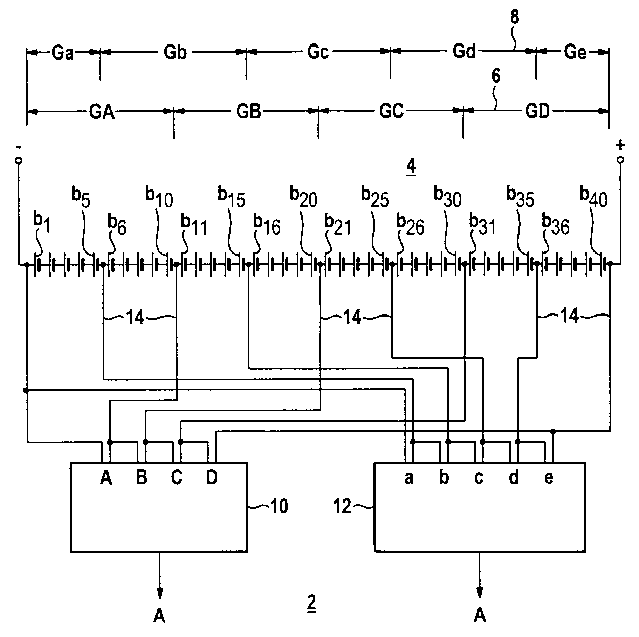

Zum besseren Verständnis der Erfindung und ihrer Weiterbildungen werden mehrere Ausführungsbeispiele anhand einer Figur erläutert. In der Figur ist ein Ausschnitt aus einer Brennstoffzellenanlage mit einem Brennstoffzellenstapel schematisch dargestellt.

In der Figur erkennt man eine Brennstoffzellenanlage 2 mit einem Brennstoffzellenstapel (Stapel 4). Der Stapel 4 enthält vierzig Brennstoffzellen (Zellen b1 bis b40). In der Regel enthält ein Stapel wenigstens 50 Zellen.

Die Zellen b1 bis b40 des Stapels 4 sind jeweils zu Gruppen zusammengefaßt. Eine erste Gruppeneinteilung 6 umfaßt die Gruppen GA,GB,GC und GD, welche jeweils 10 in Reihe geschaltete Zellen enthalten. Die Gruppe GA enthält die Zellen b1 bis b10, die Gruppe GB enthält die Zellen b11 bis b20, die Gruppe GC enthält die Zellen b21 bis b30 sowie die Gruppe GD die Zellen b31 bis b40. Eine zweite Gruppeneinteilung 8 (d. h. eine weitere Gruppeneinteilung, die die Zellen bl bis b40 anders als die erste Gruppeneinteilung 6 aufteilt) umfaßt die Gruppen Ga,Gb,Gc,Gd und Ge. Die Gruppe Ga enthält dabei die Zellen b1 bis b5. Die Gruppen Gb bzw. Gc bzw. Gd enthalten die Zellen b6 bis b15 bzw. b16 bis b25 bzw. b26 bis b35. Die Gruppe Ge enthält die Zellen b36 bis b40. In jeder Gruppeneinteilung ist also jede Zelle Mitglied von genau einer Gruppe.

Die elektrischen Spannungen werden gruppenweise erfaßt, und zwar in den der Gruppen Gi (wobei i gleich A,B,C,D,a,b,c,d und e ist). Dabei wird für jede Gruppe Gi die Eingangsspannung der ersten Zelle (beispielsweise bei der Gruppe GA die Eingangsspannung der Zelle b1) und die Ausgangsspannung der letzten Zelle dieser Gruppe Gi (bei der Gruppe GA also die Ausgangsspannung der Zelle b10) gemessen.

Die erfaßten (gemessenen) elektrischen Spannungen der Gruppen Gi werden in zwei Verarbeitungseinrichtungen 10,12 verarbeitet. Die Verarbeitungseinrichtung 10 hat die elektrischen Signaleingänge A bis D. Die Verarbeitungseinrichtung 12 hat die elektrischen Signaleingänge a bis e. Die elektrischen Signaleingänge A bzw. B bzw. C bzw. D werden die elektrischen Spannungen der Gruppen GA bzw. GB bzw. GC bzw. GD der ersten Gruppeneinteilung 6 erfaßt.

Über die elektrischen Signaleingänge a bzw. b bzw. c bzw. d bzw. e der Verarbeitungseinrichtung 12 werden die Gruppen Ga bzw. Gb bzw. Gc bzw. Gd bzw. Ge der zweiten Gruppeneinteilung 8 erfaßt.

Jede Zelle b1 bis b40 ist somit Mitglied zweier Gruppen Gi, wobei eine der beiden Gruppen Gi der ersten Gruppeneinteilung 6 und die zweite der beiden Gruppen Gi der zweiten Gruppeneinteilung 8 zugeordnet ist. Somit ist gewährleistet, daß jede Zelle b1 bis b40 parallel durch beide Verarbeitungseinrichtungen 10,12 spannungsmäßig erfaßt wird. Die Brennstoffzellenanlage 2 ist also bezüglich der Messungen der elektrischen Spannungen der Zellen b1 bis b40 (und damit der Gruppen Gi) redundant ausgelegt. Der Spannungsabgriff erfolgt über die elektrischen Leitungen 14.

Bis auf die Gruppen Ga und Ge, die jeweils nur 5 Zellen enthalten, enthalten die Gruppen Gi jeweils 10 Zellen.

Die Vorrichtung kann auch auf mehr als zwei simultan arbeitende Überwachungseinrichtungen erweitert werden, wobei jede Zelle in jeder Überwachungseinrichtung jeweils als Mitglied einer ausgewählten Gruppe überwacht wird.

Dabei ist jeder Überwachungseinrichtung die elektrische Eingangsspannung und Ausgangsspannung des Stapels 4 aufgeschaltet. Dadurch wird in jeder Einrichtung die gesamte Spannungsdifferenz des Stapels 4 als ein Mittelwert erfaßt, der - zusätzlich zu den Spannungen der jeweils überwachten, ausgewählten Gruppe - zu allen anderen Zellen des Stapels gehört. Am Stapel 4 sind mehrere Abgriffe angeordnet, die jeweils die Spannung an der elektrischen Verbindung zwischen zwei Brennstoffzellen abgreifen und in einer zyklisch alternierenden Weise gleichzeitig jeweils einer Überwachungseinrichtung 10,12 aufgeschaltet sind: Zwischen zwei dieser Abgriffe, die einer Überwachungseinrichtung (z.B. in der Figur der Überwachungseinrichtung 10) zugeordnet sind, ist für die Überwachungseinrichtung 12 und jede weitere Überwachungseinrichtung ein weiterer Spannungsabgriff vorgesehen. Um z.B. die Zelle b6 zu überwachen, werden in der Einrichtung 10 die Zelle $b_1$ bis $b_{10}$ zu der für diese Zelle $b_6$ ausgewählten Gruppe zusammengefaßt und am Signaleingang A als Gruppe erfaßt; in der Überwachungseinrichtung 12 dagegen bilden die Zellen $b_6$ bis $b_{15}$ eine für die Zelle $b_6$ ausgewählte Gruppe, deren Spannungen am Eingang b gemeinsam erfaßt sind. Entsprechend können noch weitere Zerlegungen des Stapels 4 in einzelne Gruppen vorgenommen werden, so daß die Zelle $b_6$ noch Mitglied einer entsprechend ausgewählten Gruppe für jede weitere Überwachungseinrichtung ist.

Die Zelle $b_6$ wird - entsprechend der Anzahl der Überwachungseinrichtungen - also redundant überwacht. Die Überwachung der Zelle $b_6$ mittels des Signaleingangs A (bzw. b) und einer z.B. an den beiden Enden des Stapels 4 abgegriffenen Spannung als Bezugswert der Überwachung wird weiter unten noch genau erläutert.

Gleichzeitig werden aber auch die Spannungen der anderen Gruppen entsprechend redundant überwacht. Die Zelle $b_{16}$ z.B. ist ihrerseits Mitglied der Gruppe $b_{11}$ bis $b_{20}$, deren Spannungen am Signaleingang B zusammengefaßt sind und die für die Überwachung der Zelle $b_{16}$ ausgewählte Gruppe bilden.

Jede Zelle ist durch diese Gruppeneinteilung also Mitglied einer ausgewählten Gruppe (im Falle einer einzigen Überwachungseinrichtung) oder jeweils einer für jede Überwachungseinrichtung vorgesehenen eigenen ausgewählten Gruppe. Da alle Gruppen von jeder Überwachungseinrichtung gleichzeitig nach dem Verfahren des Anspruchs 1 überwacht werden, werden bei der Vorrichtung nach der Figur also alle Zellen gleichzeitig und redundant überwacht.

Für die Überwachung einer Zelle $b_i$ (z.B. also der $b_{16}$) in einer Überwachungseinrichtung (z.B. der Einrichtung 10) ist also die Gruppe $G_i$ ausgewählt, zu der $b_i$ gehört (also für $b_{16}$ die Gruppe GB). Die zeitliche Änderung der gemittelten elektrischen Spannung der unmittelbar in Reihe geschalteten Zellen $b_{11}$ bis $b_{20}$ (also der für $b_{16}$ ausgewählten Gruppe GB) wird ermittelt und mit einem Bezugswert verglichen, der die gemessenen elektrischen Spannungen anderer Zellen (d.h. z. B. aller Zellen $b_1$ bis $b_{40}$ - oder jedenfalls anderer Zellen als der Zellen $b_{11}$ bis $b_{20}$ der Gruppe GB - des Stapels 4) und deren zeitliche Änderungen erfaßt.

Die gemittelte Spannung der Zellen in der ausgewählten Gruppe $G_i$ und im ganzen Stappel 4 ist durch $\overline{U}_i$ und $\overline{U}_o$ gegeben:

$$\overline{U}_i = U_i/n_i \text{ und } \overline{U}_o = U_o/n_o,$$

wobei $U_i$ die Spannung am entsprechenden Signaleingang der Überwachungseinrichtung 10,12 und $U_o$ die Differenz zwischen Ausgangsspannung und Eingangsspannung des Stapels 4 und $n_i,n_o$ die Zahl der Zellen der ausgewählten Gruppe $G_i$ und des ganzen Stapels 4 ist. Dabei ist berücksichtigt, daß $n_i$ für die einzelnen Gruppen unterschiedlich sein kann. Die Größen $U_i$ und $U_o$ werden als $U_{i,o}(t)$ und $U_{i,o}(t')$ jeweils zu aufeinanderfolgenden Zeitpunkten gemessen. Die relative Summenspannung der ausgewählten Gruppe $G_i$ ist

$$U_i(\text{rel}) = \overline{U}_i/\overline{U}_o.$$

Als zeitliche Änderung der gemittelten elektrischen Spannung an den Zellen der ausgewählten Gruppe $G_i$ wird eine nach unterschiedlichen Varianten gebildete Differenz der zu diesen Zeitpunkten gemessenen Spannungen gebildet und mit dem Bezugswert DB verglichen, der bevorzugt aus der Summenspannung $U_o$ und deren Änderung zwischen den Zeitpunkten $t_i$ und $t_i'$ ermittelt wird:

$$DB = \frac{\Sigma U_i(t')-\Sigma U_i(t)}{\Sigma U_i(t)} = \frac{\overline{U}_o(t')-\overline{U}_o(t)}{\overline{U}_o(t)}$$

(relative Änderung der Summenspannung aller Gruppen $G_i$)
oder

$$DB = \Sigma \frac{U_i(t')-U_i(t)}{U_i(t)}$$

(Summe der relativen Änderungen der einzelnen Gruppenspannungen).

Ebenso kann für die zu $b_i$ ausgewählte Gruppe $G_i$ die Änderung $\Delta i$ der gemittelten Spannung berechnet werden als

$$\Delta i = \frac{\overline{U}_i(t')-\overline{U}_i(t)}{\overline{U}_o(t)} \cdot 100$$

(oder bevorzugt:

$$\Delta i = \frac{U_i(t')-U_i(t)}{U_i(t)} \cdot 100)$$

(jeweils in Prozent).

Das Kriterium für ordnungsgemäße Zellen in der ausgewählten Gruppe $G_i$ lautet dann:

$$|\Delta i| < R \cdot |DB|,$$

wobei R ein fest vorgegebener Grenzwert ist (z.B. 50%).

Als ein dynamisches Verfahren, bei dem die Änderung einer Gruppenspannung mit den Änderungen der Spannungen andere (oder aller) Gruppen verglichen wird, ist diese Überwachung empfindlich auf rasche Änderungen beim Ausfall einer Brennstoffzelle, aber unempfindlich auf "schleichende" Änderungen, bei denen sich die Spannung einer Zelle langsam ändert. Im Gegensatz dazu sind bekannte statische Verfahren, wie sie eingangs beschrieben sind und auf einem Vergleich der Gruppenspannung selbst mit den Spannungen anderer (oder aller) Gruppen aufbauen, auf Spannungsänderungen erst dann empfindlich, wenn sich im Lauf der Zeit eine erhebliche Änderung der Gruppenspannung aufbaut.

Daher werden beide Überwachungskonzepte bevorzugt kombiniert. Dann werden sowohl die gemittelte Spannung der Zellen in der ausgewählten Gruppe mit einem aus anderen (oder allen) Gruppen gebildeten Spannungs-Bezugswert als auch die Änderungen dieser Größen verglichen. Dies führt z.B. zu einem zusätzlichen Kriterium

$$\left|\overline{U}_i(t')-\overline{U}_o(t')\right| < Q$$

mit einem entsprechenden Grenzwert Q (z.B. 100 mV), oder

$$\frac{\left|\overline{U}_i(t')-\overline{U}_o(t')\right|}{\left|\overline{U}_o(t')\right|} \cdot 100 < Q$$

< (z.B. Q = 20%).

Auf diese Weise könen für die Zellen jeder überwachten (ausgewählten) Gruppe $G_i$ schnelle Spannungsänderungen, wie sie beim Auftreten eines Lecks entstehen können, und langsame Änderungen, die durch allmählichen Ausfall von Komponenten entstehen, gleichzeitig detektiert werden.

**Patentansprüche**

1. Verfahren zum Überwachen einer ausgewählten Gruppe (GA) von Brennstoffzellen (b1 bis b40) eines Brennstoffzellenstapels (4), wobei die zeitliche Änderung der gemittelten elektrischen Spannung der Brennstoffzellen (bi) der ausgewählten Gruppe (GA) ermittelt und verglichen wird mit einem Bezugswert, der mindestens die zeitliche Änderung der Spannung anderer Brennstoffzellen (b11 bis b40) erfaßt.

2. Verfahren nach Anspruch 1, **dadurch gekennzeichnet**, daß die Gesamtheit der Zellen (b1 bis b40) des Brennstoffzellenstapels (4) in mehrere Gruppen (Gi) aus unmittelbar in Reihe geschalteten Brennstoffzellen (bi) aufgeteilt ist, daß bei der Ermittlung der zeitlichen Änderung der gemittelten elektrischen Spannung in der ausgewählten Gruppe (GA) auch die gemittelte Spannung in den anderen erfaßt wird, und daß die mittlere Spannung einer Gruppe (GA,Gi) jeweils nur aus der gemessenen Eingangsspannung der ersten Brennstoffzelle und der gemessenen Ausgangsspannung der letzten Brennstoffzelle dieser einen Gruppe (GA,Gi) zu zwei aufeinander folgenden Zeitpunkten gebildet wird.

3. Verfahren nach Anspruch 2, **dadurch gekennzeichnet**, daß als zeitliche Änderung der Spannungen einer Gruppe (Gi) die relative Änderung der Differenz zwischen der Eingangsspannung der ersten Brennstoffzelle und der Ausgangsspannung der letzten Brennstoffzelle dieser Gruppe ermittelt wird.

4. Verfahren nach einem der vorhergehenden Ansprüche, **dadurch gekennzeichnet**, daß als gemittelte Spannung der Brennstoffzellen der ausgewählten Gruppe (GA) die Summenspannung dieser Brennstoffzellen gemessen und durch die Zahl der Brennstoffzellen (bi) dividiert wird.

5. Verfahren nach einem der vorhergehenden Ansprüche, **dadurch gekennzeichnet**, daß als Änderung der gemittelten elektrischen Spannung der Brennstoffzellen der ausgewählten Gruppe (GA) die relative Änderung der gemessenen Summenspannung der Brennstoffzellen der ausgewählten Gruppe (GA) ermittelt wird.

6. Verfahren nach einem der vorhergehenden Ansprüche, **dadurch gekennzeichnet**, daß der Bezugswert mindestens die Spannungen aller Brennstoffzellen (bi), die nicht zur ausgewählten Gruppe gehören, und deren Änderungen erfaßt.

7. Verfahren nach einem der vorhergehenden Ansprüche, **dadurch gekennzeichnet**, daß als Bezugswert die Summe der relativen Änderungen der gemessenen Spannungen ermittelt wird.

8. Verfahren nach einem der Ansprüche 1 bis 6, **dadurch gekennzeichnet**, daß als Bezugswert die relative Änderung der Summe der gemessenen Spannungen ermittelt wird.

9. Verfahren nach einem der vorhergehenden Ansprüche, **dadurch gekennzeichnet**, daß zusätzlich die gemittelte Spannung der ausgewählten Gruppe (Gi) verglichen wird mit einem Mittelwert, der die Spannungen aller Brennstoffzellen oder mindestens anderer Brennstoffzellen des Stapels (4) erfaßt.

10. Verfahren nach einem der vorhergehenden Ansprüche, **dadurch gekennzeichnet**, daß gleichzeitig die Spannungen aller Brennstoffzellen (bi) des Stapels (4) erfaßt werden, wobei jede Brennstoffzelle (bi) als Mitglied einer ausgewählten Gruppe (Gi) überwacht wird.

11. Verfahren nach einem der vorhergehenden Ansprüche, **dadurch gekennzeichnet**, daß jede Brennstoffzelle (bi) des Stapels (4) redundant als Mitglied mindestens zweier ausgewählter Gruppen (Gi) überwacht wird.

12. Verfahren nach Anspruch 11, **dadurch gekennzeichnet**, daß die redundante Überwachung mittels redundanter Überwachungseinrichtungen (10,12) für die gemessenen Spannungen vorgenommen wird.

13. Vorrichtung zum Überwachen in Reihe geschalteten Brennstoffzellen (b1 bis b40) eines Brennstoffzellenstapels (4), mit mindestens zwei Überwachungseinrichtungen (10,12), wobei zu einem vorgegebenen Zeitpunkt

a) jeder Überwachungseinrichtung (10,12) die elektrische Eingangsspannung und Ausgangsspannung des ganzen Stapels (4) aufgeschaltet sind,

b) jeder Überwachungseinrichtung (10,12) über Abgriffe und Signaleingänge mehrere Spannungen aufgeschaltet sind, die jeweils zwischen benachbarten Brennstoffzellen abgegriffen sind, wobei mindestens zwischen zwei Abgriffen, die einer Überwachungseinrichtung (10) aufgeschaltet sind, mindestens ein Abgriff mit einer zu einer anderen Überwachungseinrichtung (12) führenden Signalleitung (14) angeordnet ist, und in jeder Überwachungseinrichtung (10,12) eine Rechenstufe aktivierbar ist, die mehrere Differenzen der zu diesem Zeitpunkt aufgeschalteten Spannungen mit entsprechenden zu einem früheren Zeitpunkt aufgeschalteten Differenzen vergleicht.

14. Vorrichtung nach Anspruch 13, **dadurch gekennzeichnet**, daß jeweils zwischen zwei Abgriffen, die mit der gleichen Überwachungseinrichtung (10) verbunden sind, jeweils ein Abgriff für jede andere Überwachungseinrichtung (12) angeordnet ist.

**Claims**

1. Method for monitoring a selected group (GA) of fuel cells (b1 to b40) of a fuel-cell stack (4), wherein the change over time in the averaged electric voltage of the fuel cells (bi) in the selected group (GA) is established and compared with a reference value, which records at least the change over time in the voltage of other fuel cells (b11 to b40).

2. Method according to claim 1, characterised in that all of the cells (b1 to b40) of the fuel-cell stack (4) are divided into a plurality of groups (Gi) of directly series-connected fuel cells (bi), in that during the establishing of the change over time in the averaged electric voltage in the selected group (GA), the averaged voltage in the others is also recorded, and in that the mean voltage of a group (GA, Gi) is formed in each case only from the measured input voltage of the first fuel cell and the measured output voltage of the last fuel cell of this one group (GA, Gi) at two successive instants.

3. Method according to claim 2, characterised in that established as the change over time in the voltages of a group (Gi) is the relative change in the difference between the input voltage of the first fuel cell and the output voltage of the last fuel cell of this group.

4. Method according to one of the preceding claims, characterised in that to give the averaged voltage of the fuel cells of the selected group (GA), the summation voltage of these fuel cells is measured and divided by the number of fuel cells (bi).

5. Method according to one of the preceding claims, characterised in that established as the change in the averaged electric voltage of the fuel cells of the selected group (GA) is the relative change in the measured summation voltage of the fuel cells of the selected group (GA).

6. Method according to one of the preceding claims, characterised in that the reference value records at least the voltages of all fuel cells (bi) which do not belong to the selected group and changes in said voltages.

7. Method according to one of the preceding claims, characterised in that the sum of the relative changes in the measured voltages is established as the reference value.

8. Method according to one of claims 1 to 6, characterised in that the relative change in the sum of the measured voltages is established as the reference value.

9. Method according to one of the preceding claims, characterised in that additionally, the averaged voltage of the selected group (Gi) is compared with a mean value which records the voltages of all fuel cells or at least of other fuel cells of the stack (4).

10. Method according to one of the preceding claims, characterised in that simultaneously, the voltages of all fuel cells (bi) of the stack (4) are recorded, with each fuel cell (bi) being monitored as member of a selected group (Gi).

11. Method according to one of the preceding claims, characterised in that each fuel cell (bi) of the stack (4) is monitored redundantly as member of at least two selected groups (Gi).

12. Method according to claim 11, characterised in that the redundant monitoring by means of redundant monitoring devices (10, 12) is carried out for the measured voltages.

13. Arrangement for monitoring series-connected fuel cells (b1 to b40) of a fuel cell stack (4) having at least two monitoring devices (10, 12), wherein at a predetermined instant

a) the electrical input voltage and output voltage of the entire stack (4) are applied to each monitoring device (10, 12),

b) by way of pick-ups and signal inputs, a plurality of voltages are applied to each monitoring device (10, 12), which voltages are picked up in each case between adjacent fuel cells, in which case arranged at least between two pick-ups which are applied to a monitoring device (10) is at least one pick-up having a signal line (14) leading to another monitoring device (12), and in each monitoring device (10, 12) an arithmetic stage can be activated which compares a plurality of differences in the voltages applied at this instant with corresponding differences applied at an earlier instant.

14. Arrangement according to claim 13, characterised in that arranged in each case between two pick-ups which are connected to the same monitoring device (10) is a respective pick-up for each other monitoring device (12).

## Revendications

1. Procédé de surveillance d'un groupe (GA) sélectionné de piles (b1 à b40) à combustible d'un empilement (4) de piles à combustible, dans lequel on détermine la variation en fonction du temps de la tension électrique moyenne des piles (bi) à combustible du groupe (GA) choisi et on la compare à une valeur de référence qui appréhende au moins la variation en fonction du temps de 1a tension d'autres piles (b11 à b40) à combustible.

2. Procédé suivant la revendication 1, caractérisé en ce que l'on subdivise la totalité des piles (b1 à b40) de l'empilement (4) de piles à combustible en plusieurs groupes (Gi) constitués de piles (bi) à combustible montées directement en série, en ce que lors de la détermination de la variation en fonction du temps de la tension électrique moyenne dans le groupe (GA) sélectionné, on relève également la tension moyenne dans les autres groupes et en ce que l'on ne forme la tension moyenne d'un groupe (GA, Gi) respectivement qu'à partir de la tension d'entrée mesurée de la première pile à combustible et de la tension de sortie mesurée de la dernière pile à combustible de ce un groupe (GA, Gi) en deux instants successifs.

3. Procédé suivant la revendication 2, caractérisé en ce que l'on détermine comme variation en fonction du temps des tensions d'un groupe (Gi) la variation relative de la différence entre la tension d'entrée de la première pile à combustible et la tension de sortie de la dernière pile à combustible de ce groupe.

4. Procédé suivant l'une des revendications précédentes, caractérisé en ce que comme tension moyenne des piles à combustible du groupe (GA) choisi on mesure la tension somme de ces piles à combustible et on la divise par le nombre des piles (bi) à combustible.

5. Procédé suivant l'une des revendications précédentes, caractérisé en ce que comme variation de la tension électrique moyenne des piles à combustible du groupe (GA) sélectionné, la variation relative de la tension somme mesurée des piles à combustible du groupe (GA) sélectionné.

6. Procédé suivant l'une des revendications précédentes, caractérisé en ce que la valeur de référence appréhende au moins la tension de toutes les piles (bi) à combustible qui n'appartiennent pas au groupe sélectionné et leur variation.

7. Procédé suivant l'une des revendications précédentes, caractérisé en ce que l'on détermine comme valeur de référence la somme des variations relatives des tensions mesurées.

8. Procédé suivant l'une des revendications 1 à 6, caractérisé en ce que l'on détermine comme valeur de référence la variation relative de la somme des tensions mesurées.

9. Procédé suivant l'une des revendications précédentes, caractérisé en ce que l'on compare en outre la tension moyenne du groupe (Gi) sélectionné à une valeur moyenne qui appréhende les tensions de toutes les piles à combustible ou au moins d'autres piles à combustible de l'empilement (4).

10. Procédé suivant l'une des revendications précédentes, caractérisé en ce que l'on relève simultanément les tensions de toutes les piles (bi) à combustible de l'empilement (4), chaque pile (bi) à combustible étant surveillée en tant que membre d'un groupe (Gi) sélectionné.

11. Procédé suivant l'une des revendications précédentes, caractérisé en ce que l'on surveille chaque pile (bi) à combustible de l'empilement (4) de manière redondante en tant que membre d'au moins deux groupes (Gi) sélectionnés.

12. Procédé suivant la revendication 11, caractérisé en ce que l'on effectue la surveillance redondante au moyen de dispositifs (10, 12) de surveillance redondants pour les tensions mesurées.

13. Dispositif de surveillance de piles (b1 à b40) à combustible montées en série d'un empilement (4) de piles à combustible ayant au moins deux dispositifs (10, 12) de surveillance, dans lequel à un instant prescrit

a) on applique à chaque dispositif (10, 12) de surveillance la tension électrique d'entrée et la tension de sortie de tout l'empilement (4),
b) on applique à chaque dispositif (10, 12) de surveillance par des prises et des entrées de signaux plusieurs tensions qui sont prises respectivement entre des piles à combustible voisines, au moins une prise ayant une ligne (14) de signal menant à un autre dispositif (12) de surveillance étant disposée entre au moins deux prises qui sont appliquées à un dispositif (10) de surveillance et dans chaque dispositif (10, 12) de surveillance un étage de calcul pouvant être activé, cet étage comparant les plusieurs différences des tensions appliquées à cet instant à des différences correspondantes appliquées à un instant précédent.

**14.** Dispositif suivant la revendication 13, caractérisé en ce que respectivement entre deux prises qui sont reliées au même dispositif (10) de surveillance il est monté respectivement une prise pour chaque autre dispositif (12) de surveillance.